# EUROPEAN PATENT SPECIFICATION

(11) **EP 0 549 296 B1**
(45) Date of publication and mention of the grant of the patent: **30.07.1997**
(21) Application number: 92311636.2
(22) Date of filing: 21.12.1992
(51) Int. Cl.: H03D 7/14

(54) **R.F. Mixer**
Hochfrequenzmischer
Mélangeur radiofréquence

(30) Priority: 24.12.1991 GB 9127359
(43) Date of publication of application: 30.06.1993
(73) Proprietor: GEC-MARCONI LIMITED, Stanmore, Middlesex HA7 4LY (GB)
(72) Inventor: Cox, Ian Francis, Old Harlow, Essex, CM17 0BJ (GB)
(74) Representative: Waters, Jeffrey

(56) References cited:
- ELECTRONIC ENGINEERING May 1986, LONDON GB pages 53 - 56 OXNER 'high dynamic range mixing with the Si8901'
- IEEE TRANSACTIONS ON CIRCUITS AND SYSTEMS vol. 35, no. 2, February 1988, NEW YORK US pages 254 - 256 KAZIMIERCZUK 'high-speed driver for power MOSFET's'

## Description

This invention relates to r.f. mixers, i.e. mixers for frequency-changing an input signal.

The invention is particularly concerned with mixers using FET switching devices for connecting the input and output e.g. the being FETs arranged in a double balanced i.e. bridge form.

The alternate reversing of the connections between the input and the output may be effected by driving the gate electrodes of the FETs in each pair of opposite branches in anti-phase at local oscillator frequency.

In order to obtain high linearity in the mixer performance, the FETs must be switched as rapidly as possible, and this implies using a square wave to drive the gate electrodes.

A transformer has been used to provide such a drive, but a square wave requires a broad bandwidth if the rise and fall times are to be rapid. This can only be achieved if the transformer is terminated in a low impedance but, since the output impedance of the gates is capacitive, this requires a defined low resistance shunted across the output of the transformer drive, which would dissipate power.

One way in which a low power drive input to the FETs has been achieved is by employing a resonant circuit of which the capacitances of the FETs formed part (Electronic Engineering, May 1986, Ed Oxner, "High Dynamic Range mixing with the Si 8901", pages 53-56), but then a square wave drive could not be used. A square wave drive has been proposed (IEEE Transactions on Circuits and Systems vol. 35 no. 2, February 1988, New York, U.S. pages 254-256 Kazimierczuk 'High-Speed Driver for Power MOSFET's') as a high speed driver for FETs using a pair of complementary transistors, controlled by the square wave so that one transistor is on and one is off in alternation, but power is dissipated as each transistor switches on because of the need to cancel stored charge in the other due to its previous, saturation, state.

The invention provides a mixer for changing an r.f. signal to an output signal at a different frequency, comprising an input for the r.f. signal, an output for the signal at the different frequency, a pair of insulated gate FET switching devices coupled to the input and coupled to the output, a drive circuit for applying a varying voltage to the FET gates for repetitively charging and discharging the capacitance of the FET gates to switch the FET switching devices on and off at a local oscillator frequency, characterised in that the drive circuit includes, for each FET switching device of the pair, a pair of resistance capacitance differentiating circuits the inputs of which are adapted to receive the local oscillator signal in antiphase to that forming the inputs to the other differentiating circuits, and the outputs of which are coupled to the control electrode of a respective transistor of a pair, so that output electrodes of those transistors produce pulse waveforms at the FET gate to switch the respective FET on and off.

The pulse waveforms permit rapid switching of the FETs (and hence high linearity) and low power consumption, making it possible for each transistor to have time to come out of saturation after each pulse and not dissipate part of the next pulse from the other transistor in the cancellation of stored charge.

The transistors may be a complementary pair and may be driven from a square wave local oscillator drive.

An r.f. mixer constructed in accordance with the invention will now be described by way of example with reference to the accompanying drawings, in which:
Figure 1 is a circuit diagram of the mixer; and
Figure 2 shows waveforms at various points in the circuit.

The mixer includes a transformer 1 to the primary of which the r.f. input is applied and a transformer 2 from the secondary of which the i.f. output is obtained. The secondaries of both transformers are centre tapped to earth and the ends of the windings are applied to opposite points of a bridge of four MOSFETs 3a, 3b, 3c, 3d. The gates of FETs 3a, 3c and 3b, 3d in opposite arms are connected together and driven in antiphase so that MOSFETs 3a and 3c conduct together in alternation with MOSFETs 3b and 3d. A local oscillator 4 feeds square wave oscillations in antiphase with respect to each other to points A and B of MOSFET drive circuit 5, in which the signals are amplified.

The drive circuit 5 has positive and negative rails +V and -V between which are connected two pairs 6, 7; 8, 9 of complementary n-p-n, p-n-p, transistors. The bases of these transistors are driven by the antiphase local oscillator drive waveforms via respective capacitors 6a, 7a, 8a and 9a. Respective bias components 6b-6d etc are also provided. The negative rail -V is also connected to the substrates s of all the MOSFETs.

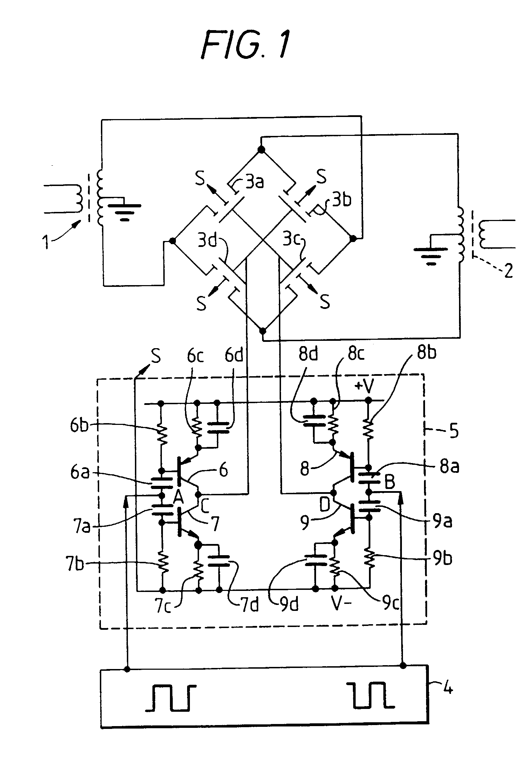

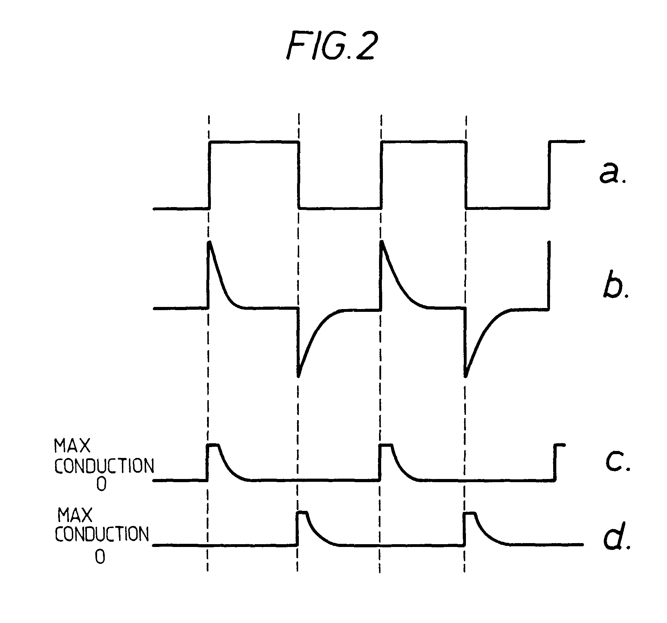

Referring to Figure 1, the voltage waveform at both points A and B are of the form shown in Figure 2a. After differentiation by the capacitors 6a - 9a the voltage waveform appearing at the bases of the transistors 6 to 9 is of the form shown in Figure 2b. The effect of this base voltage is to repetitively switch on the n-p-n transistors 7, 9 at times shown in Figure 2c and the p-n-p transistors 6, 8 at times shown in Figure 2d. Figures 2c and 2d show the conduction of the transistors as a percentage of full conduction i.e. saturation.

When transistor 8 is switched on the gate electrodes of FETs 3a and 3c are positive with respect to the channel and the FETs 3a and 3c are rapidly switched on. The relatively large current through the transistors only has to charge the gate capacitance of the FETs and the rise time is accordingly rapid. At the same time, the antiphase waveform causes transistor 7 to apply a negative voltage to the gate electrodes of FETs 3b and 3d to switch them off.

The switch-on of the FETs is rapid, promoting linearity of the mixer, because a large current flows to the gate electrodes from the transistors and because each transistor has ceased to be in saturation by the time the other transistor of the complementary pair switches on. Were this not the case, part of the current developed at switch-on of each transistor would have to cancel stored charge in the other transistor, delaying the rise time of the current pulse. The pulse nature of the waveform also results in low power consumption of the local oscillator drive circuit.

The positive and negative rails may be ±10V, and the mixer is suitable for any r.f. signal, particularly HF (3-30MHz) signals. The local oscillator signal may be up to 250MHz. These parameters may vary depending on the characteristics of devices used.

Of course other variations may be made without departing from the scope of the invention. Thus, the matched pair of transistors 6, 7 8, 9 may be replaced by FETs, and while the MOSFETs are p-channel insulated gate enhancement type semiconductor devices, n-channel MOSFETs may be used and insulated gate FETs of the depletion type may be used, or any other type of FET may be used. Also, while a double balanced form of mixer has been described, the invention is also applicable to a single balanced form. Furthermore, transmission-line style transformers may be used in place of the conventional transformers 1, 2 shown.

## Claims

1. A mixer for changing an r.f. signal to an output signal at a different frequency, comprising an input for the r.f. signal, an output for the signal at the different frequency, a pair (3a, c; 3b,d) of insulated gate FET switching devices coupled to the input and coupled to the output, a drive circuit (5) for applying a varying voltage to the FET gates for repetitively charging and discharging the capacitance of the FET gates to switch the FET switching devices on and off at a local oscillator frequency, characterised in that the drive circuit includes, for each FET switching device of the pair, a pair of resistance capacitance differentiating circuits (6a, 6b, 7a, 7b; 8a, 8b, 9a, 9b) the inputs of which are adapted to receive the local oscillator (4) signal in antiphase to that forming the inputs to the other differentiating circuits, and the outputs of which are coupled to the control electrode of a respective transistor (6, 7; 8, 9) of a pair, so that output electrodes of those transistors produce pulse waveforms at the FET gate to switch the respective FET on and off.

2. A mixer as claimed in claim 1, in which each pair of transistors forms a complementary pair.

3. A mixer as claimed in claim 1 or claim 2, in which the FETs are MOSFETs.

## Patentansprüche

1. Mischer zum Ändern eines HF-Signals zu einem Ausgangssignal bei einer unterschiedlichen Frequenz mit einem Eingang für das HF-Signal, einem Ausgang für das Signal bei der unterschiedlichen Frequenz, einem Paar (3a, c; 3b, d) FET-Schalteinrichtungen mit isoliertem Gate, die mit dem Eingang gekoppelt sind und mit dem Ausgang gekoppelt'sind, einem Ansteuerungsschaltkreis (5) zum Anlegen einer variierenden Spannung an die FET-Gates zum wiederholten Aufladen und Entladen der Kapazität der FET-Gates, um die FET-Schalteinrichtungen bei einer Lokaloszillatorfrequenz ein- und auszuschalten, dadurch gekennzeichnet, daß der Ansteuerungsschaltkreis für jede FET-Schalteinrichtung des Paares ein Paar Widerstand-Kapazität-Differenzierschaltkreise (6a, 6b, 7a, 7b; 8a, 8b, 9a, 9b) umfaßt, deren Eingänge angepaßt sind, das Lokaloszillator-(4)-Signal gegenphasig zu dem zu empfangen, das die Eingänge in die anderen Differentierschaltkreise bildet, und deren Ausgänge mit der Steuerelektrode eines jeweiligen Transistors (6, 7; 8, 9) eines Paares gekoppelt sind, so daß Ausgangselektroden jener Transistoren Pulswellenformen bei dem FET-Gate erzeugen, um den jeweiligen FET ein- und auszuschalten.

2. Mischer nach Anspruch 1, in welchem jedes Paar Transistoren ein komplementäres Paar bildet.

3. Mischer nach Anspruch 1 oder 2, in welchem die FETs MOSFETs sind.

## Revendications

1. Mélangeur pour la modification d'un signal R.F. en un signal de sortie avec une fréquence différente, comprenant une entrée pour le signal R.F., une sortie pour le signal à la fréquence différente, une paire (3a, 3c; 3b, 3d) de dispositifs de commutation FET à isolation de grille couplés à l'entrée et à la sortie, un circuit d'attaque (5) pour l'application d'une tension variable aux grilles de FET pour la charge et la décharge, de façon répétée, de la capacitance des grilles de FET afin de commuter les dispositifs de commutation FET ON et OFF selon une fréquence d'oscillateur local,
mélangeur caractérisé en ce que le circuit d'attaque comprend, pour chaque dispositif de commutation FET de la paire, une paire de circuits de différenciation à capacitance et résistance (6a, 6b, 7a, 7b; 8a, 8b, 9a, 9b) dont les entrées sont prévues pour recevoir le signal d'oscillateur local (4) en opposition de phase avec celui formant les entrées des autres circuits de différenciation, et dont les sorties sont couplées à l'électrode de commande d'un transistor respectif (6, 7; 8, 9) d'une paire de telle façon que les électrodes de sortie de ces transistors produisent des formes d'onde d'impulsion sur la grille du FET pour commuter le FET respectif ON et OFF.

2. Mélangeur selon la revendication 1, dans lequel chaque paire de transistors forme une paire complémentaire.

3. Mélangeur selon la revendication 1 ou 2, dans lequel les FETs sont des MOSFETs.
